(19) Europäisches Patentamt / European Patent Office / Office européen des brevets

(11) **EP 2 756 923 B1**

(12) **FASCICULE DE BREVET EUROPEEN**

(45) Date de publication et mention de la délivrance du brevet:
**21.11.2018 Bulletin 2018/47**

(51) Int Cl.:
***B25B 5/06*** *(2006.01)*      ***B25B 7/12*** *(2006.01)*
***G01R 1/22*** *(2006.01)*

(21) Numéro de dépôt: **14151222.8**

(22) Date de dépôt: **15.01.2014**

(54) **Pince de mesure notamment de boucle de terre du type comprenant une mâchoire solidaire d'un support fixe et une mâchoire montée pivotante sur le support**

Messzange, insbesondere für Erdschleife, mit einer festen Spannbacke auf einer festen Halterung und einer schwenkbaren Spannbacke auf der Halterung

Clamp meter, in particular for an earth loop, including a jaw secured to a stationary mounting and a jaw pivotably mounted on the mounting

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.01.2013 FR 1350458**

(43) Date de publication de la demande:
**23.07.2014 Bulletin 2014/30**

(73) Titulaire: **CHAUVIN ARNOUX**
**75018 Paris (FR)**

(72) Inventeurs:
• **Legros, Philippe**
  **75018 Paris (FR)**
• **Rouillard, Thierry**
  **75018 Paris (FR)**

(74) Mandataire: **Berger, Helmut**
**Cabinet Weinstein**
**176 avenue Charles de Gaulle**
**92200 Neuilly sur Seine (FR)**

(56) Documents cités:
**EP-A1- 0 836 099**     **FR-A1- 2 562 316**
**GB-A- 2 099 159**     **US-A- 2 842 739**

EP 2 756 923 B1

**Description**

L'invention concerne une pince de mesure notamment de boucle de terre du type comprenant une mâchoire solidaire d'un support fixe et une mâchoire montée pivotante sur le support, entre une position de fermeture de la pince dans laquelle l'extrémité de la mâchoire mobile est en contact pressé avec l'extrémité de la mâchoire fixe et une position d'ouverture de la pince, et un élément élastique de rappel de la mâchoire mobile dans sa position de fermeture, la mâchoire mobile étant formée par un bras d'un levier à deux bras, qui est monté pivotant sur le support fixe, dont l'autre bras constitue la gâchette d'entraînement en pivotement du levier

Des pinces de mesure de boucle de terre de ce type sont déjà connues. La problématique générale de ces pinces est d'avoir une pression de fermeture des deux mâchoires l'une sur l'autre la plus importante possible pour minimiser l'entrefer entre les faces de contact des deux mâchoires. Pour arriver à cet objectif, les pinces sont conçues pour nécessiter un effort d'ouverture de mâchoire très important, ce qui est très gênant pour l'utilisateur. Cet effort se situe aux alentours de 60 Newtons au démarrage de l'ouverture pour arriver à 140 Newtons lors du maintien de la pince à l'état totalement ouverte. En effet, plus on ouvre la pince, plus l'effort augmente.

Un document pertinent de l'état de la technique divulguant une pince ampèremétrique est le document EP 0 836 099 A1.

L'invention a pour but de pallier cet inconvénient.

Pour atteindre ce but, la pince selon l'invention est caractérisée en ce qu'elle comprend un dispositif de démultiplication de la force d'ouverture de la pince, par son application sur la gâchette, qui est monté entre l'élément élastique de rappel et la gâchette, et adapté pour réduire la force d'ouverture lors de l'ouverture.

Selon une caractéristique de l'invention, le dispositif de démultiplication comprend un agencement de biellettes, qui est monté entre l'extrémité mobile de l'élément élastique dont l'autre extrémité est reliée à un axe d'articulation monté fixe sur le support, le bras porteur de la mâchoire mobile (4) du levier à deux bras et le support et est le support.

Selon une autre caractéristique de l'invention, le dispositif de démultiplication est adapté pour réduire lors du pivotement de la pince dans sa position ouverte, le moment autour de l'axe de pivotement du levier, que produit la force s'opposant à l'ouverture de la pince, sous l'effet du ressort de rappel.

Selon encore une autre caractéristique de l'invention le dispositif de démultiplication est adapté pour réduire, lors du pivotement de la pince dans sa position ouverte, la longueur du bras du moment de la force d'opposition autour de l'axe de pivotement du levier à deux bras.

Selon encore une autre caractéristique de l'invention, la pince comprend deux biellettes dont l'une est interposée entre le bras porteur de la mâchoire mobile et un axe d'articulation à l'extrémité mobile de l'élément de rappel et une biellette qui est interposée entre l'axe d'articulation et l'axe d'articulation fixe de façon à forcer, lors de l'ouverture de la pince, l'axe à se déplacer sur un arc de cercle autour de l'articulation fixe, que la force d'opposition à l'ouverture est fonction de la force de rappel de l'élément de rappel et du rapport de la longueur du bras du moment produit par la force de rappel autour de l'axe d'articulation fixe et de la longueur du bras autour de l'axe fixe du moment de la force d'opposition, et en ce que le rapport des deux bras diminue lors de l'ouverture de la pince grâce au déplacement de l'axe d'articulation mobile sur l'arc de cercle.

Selon encore une autre caractéristique de l'invention le moment de la force d'application autour de l'axe de pivotement du levier est égale au moment de la force d'opposition autour de l'axe.

Selon encore une autre caractéristique de l'invention, le bras du moment de la force d'opposition autour de l'axe de pivotement du levier à deux bras diminue lors du pivotement du levier dans la position ouverte de la pince.

Selon une autre caractéristique de l'invention l'élément élastique est un ressort de traction.

L'invention sera mieux comprise, et d'autres buts, caractéristiques, détails et avantages de celle-ci apparaîtront plus clairement dans la description explicative qui va suivre faite en référence aux dessins annexés donnés uniquement à titre d'exemple illustrant un mode de réalisation de l'invention et dans lesquels :

- la figure 1 est une vue en perspective d'une pince de mesure de boucle de terre du type de la pince selon l'invention ;
- la figure 2 est une vue schématique d'une pince de mesure de boucle de terre selon l'invention, montrant cette pince dans sa position de fermeture ;
- la figure 3 montre la pince selon la figure 2 dans sa position d'ouverture ;
- les figures 4 et 5 sont des vues schématiques explicatives du fonctionnement du dispositif de biellettes selon l'invention en montrant ce dispositif lorsque la pince est respectivement fermée et ouverte.

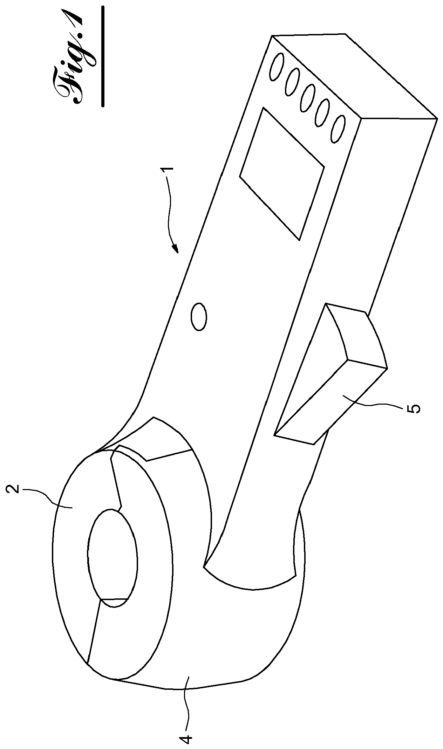

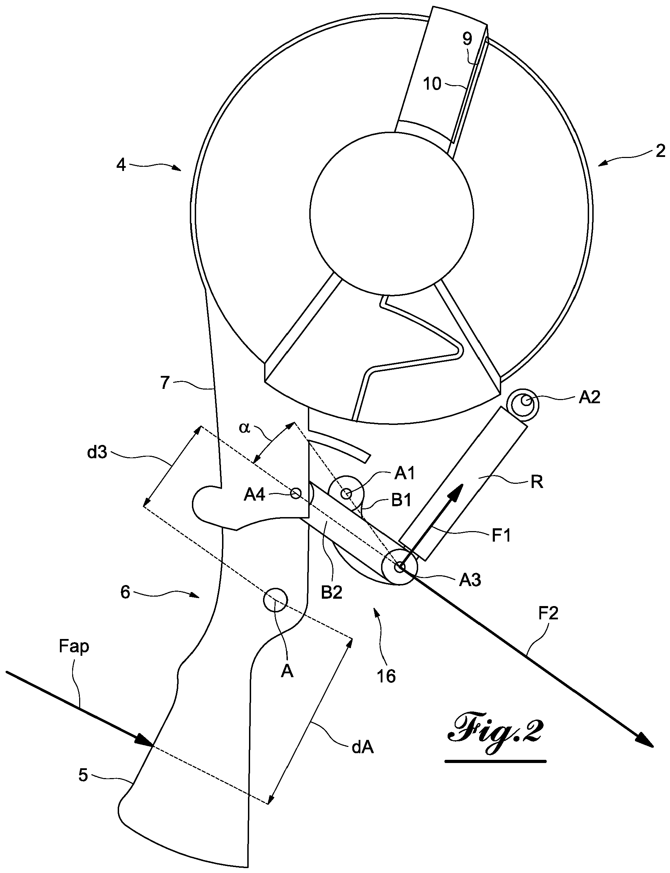

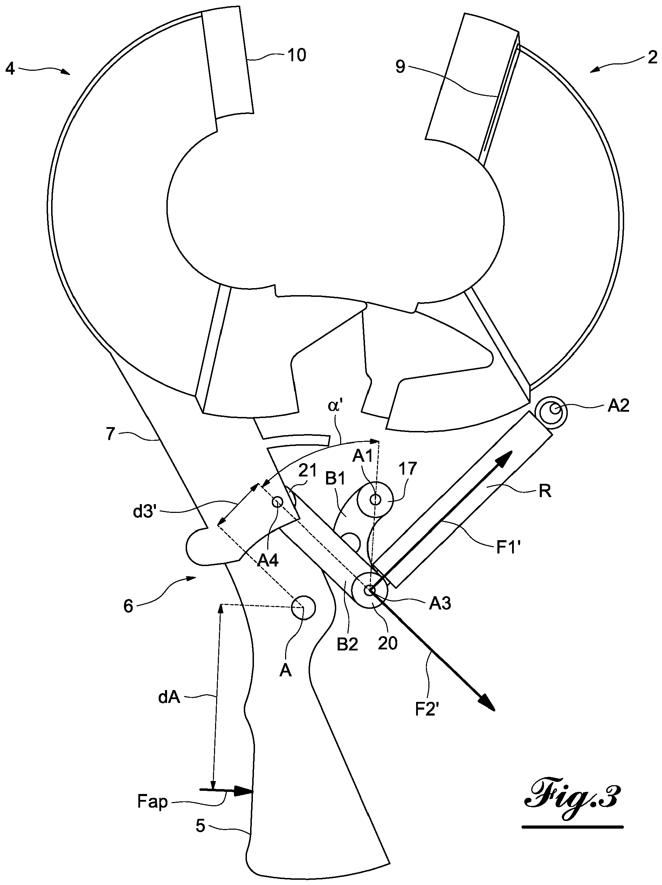

Comme le montre la figure 1, une pince de mesure de boucle de terre comprend une partie formant boîtier 1 dont est solidaire une partie 2 constituant la mâchoire fixe de la pince et une mâchoire 4 mobile entre la position fermée de la pince représentée aux figures 1 et 2 et une position ouverte selon la figure 3, dont le mouvement est commandé par un organe formant gâchette 5 que l'utilisateur enfonce dans le boîtier 1 pour ouvrir la pince.

En se reportant aux figures 2 et 3, on constate que la gâchette 5 constitue un bras 5 d'un levier 6 à deux bras, qui est monté pivotant autour d'un axe A. Cet axe est monté sur un support fixe du boîtier. La mâchoire mobile 4 est portée par le deuxième bras 7 du levier 6.

Les figures 2 et 3 montrent que les mâchoires 2 et 4 présentent la forme d'arcs de cercle. Dans leur position de fermeture de la pince, les faces frontales d'extrémité 9, 10 des mâchoires 2 et 4 sont en contact pressé sur toute leur surface.

Le mécanisme de commande de l'ouverture et de fermeture de la pince comprend essentiellement un ressort R et un dispositif 16 constitué et agencé de façon à assurer une démultiplication des efforts à l'ouverture et à la fermeture de la pince 1. Le ressort R est relié par une extrémité à un axe d'articulation fixe A2, c'est-à-dire monté fixe sur un support du boîtier.

Le dispositif démultiplicateur 16 comprend, dans l'exemple représenté, une première biellette courbe B1 qui est reliée par une extrémité 17 à un axe de rotation fixe A1 tandis que son autre extrémité 18 sert d'axe d'articulation mobile A3 lié au ressort R et à une extrémité 20 d'une deuxième biellette B2 du dispositif démultiplicateur. L'autre extrémité 21 de la biellette B2 qui est une biellette rectiligne est reliée à l'axe d'articulation A4 prévu sur le bras 7 du levier 6 qui tourne autour de l'axe fixe A et dont l'autre bras constitue la gâchette de commande 5. Le ressort R, un ressort hélicoïdal, est orienté sensiblement rectangulairement au bras B2 lorsque la pince est fermée. Il est actionné en traction lors de l'ouverture de la pince.

Le fonctionnement du dispositif démultiplicateur ressortira de la description de la pince selon l'invention qui sera donnée ci-après.

Lorsque l'utilisateur souhaite ouvrir la pince en l'amenant de sa position de fermeture de la figure 2 à la position d'ouverture selon la figure 3, il applique une force de pression Fap sur la gâchette 5 qui fait tourner le levier 6 dans la direction D1 autour de l'axe fixe A, ce qui provoque le déplacement de l'axe A4 sur le bras 7 du levier en direction de la flèche D2. La biellette rectiligne B2 qui est articulé à l'axe A4 occasionne le déplacement de l'axe A3 auquel est articulé le ressort R. Mais, la biellette courbe B1 oblige l'axe A3 de se déplacer sur un arc de cercle autour de l'axe fixe A1.

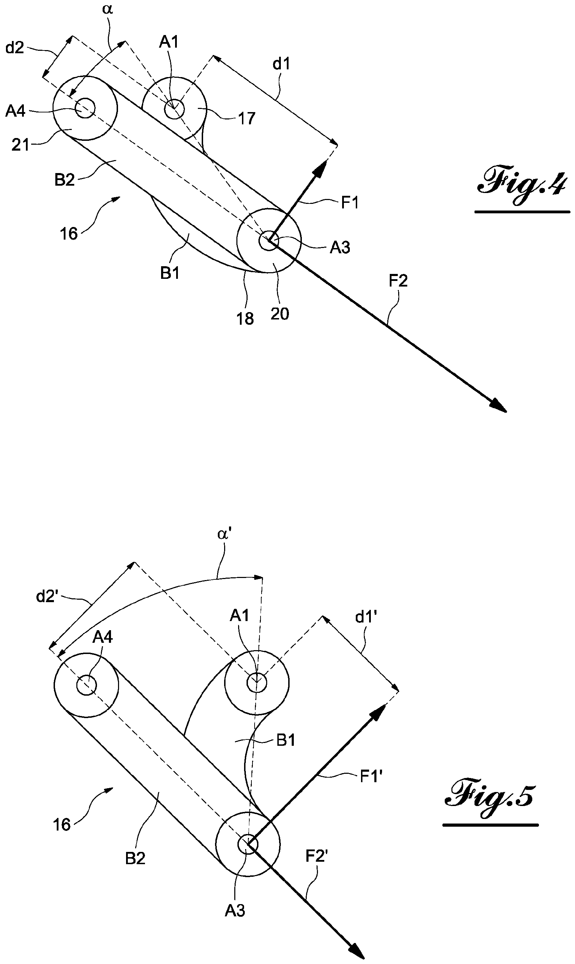

Les figures 4 et 5 expliquent l'effet démultiplicateur que produit le dispositif démultiplicateur 16. La figure 4 montre ce dispositif formé par les deux biellettes B1 et B2 à l'état lorsque la pince est fermée. Le ressort R, dans cette position du dispositif, exerce un effort $F_1$ sur l'axe A3, ce qui crée un moment autour de l'axe fixe A1 qui est égal à la force $F_1$ multipliée par le bras de couple d1. Le ressort crée aussi, due aux biellettes B1 et B2, une force F2 qui agit en direction de la biellette rectiligne B2. Cette force fait naître un moment $M_2$ qui est égal au produit de cette force F2 et du bras d2, également autour de l'axe fixe A1.

Etant donné que l'axe A1 est stationnaire, les deux moments doivent être égaux. Il en suit les relations :

$$M_{F1} \; = \; M_{F2}$$

$$F_1 \; x \; d1 \; = \; F_2 \; x \; d2$$

Lorsque la pince se trouve dans sa position ouverte, représentée à la figure 3, avec le dispositif 16 selon la figure 5, les deux moments agissent de la même manière qu'à l'état fermé de la pince, mais les longueurs des bras d1 et d2 ont changé et sont devenues d1' et d2'. La force de rappel du ressort est devenue la force $F_1$' et la force $F_2$ la force $F_2$'. Mais, comme auparavant, on peut écrire :

$$F_1' \; x \; d1' \; = \; F_2' \; x \; d2'$$

Les forces $F_2$ et $F_2$' s'opposant à l'ouverture de la pince aux états respectivement fermé et ouvert, peuvent être déterminées par les équations suivantes :

$$F_2 = \frac{F_1 \times d_1}{d_2} \quad ; \quad F_2' = \frac{F_1' \times d_1'}{d_2'}$$

On constate que les forces $F_2$ et $F_2$' dépendent de la force $F_1$, $F_1$' du ressort R et du rapport des longueurs des bras $\dfrac{d_1}{d_2}$ et $\dfrac{d_1'}{d_2'}$ des moments.

La particularité de l'invention réside notamment dans la découverte qu'en modifiant le rapport des bras des moments lors de l'ouverture de la pince, la force s'opposant à l'ouverture peut être amenée à ne plus dépendre essentiellement du ressort de rappel R.

En se référant aux figures 4 et 5, on constate que le bras d2 est deux ou trois fois plus court que le bras d1, alors que, à l'état ouvert de la pince, le bras d1' est plus court que le bras d2' ce qui a pour conséquence que la force F2 de maintien de la pince à l'état ouvert est nettement inférieur à la force F2 d'ouverture de la pince.

Concernant les moments exercés par les forces F2 et F2' autour de l'axe A sur le bras de mâchoire on obtient

$$MA = F_2 \ x \ d3$$

$$MA' = F_2' \ x \ d3'$$

d3 et d3' étant des bras des moments autour de l'axe A.

Pour ouvrir la pince et pour la maintenir à l'état ouvert, il faut appliquer à la gâchette des forces

$$Fap = \frac{MA}{dA}$$

$$Fap' = \frac{MA'}{dA}$$

dA étant la longueur du bras des moments autour de l'axe A, des forces d'application Fap.

On constate sur les figures 4 et 5 que le bras de moment d3' de la pince ouverte est plus court que le bras d3 de la pince fermée, ce qui a pour conséquence que la force Fap à appliquer sur la gâchette pour maintenir la pince ouverte est considérablement plus faible que la force pour l'ouvrir, du fait que le moment MA' est beaucoup plus faible que le moment MA.

Pour obtenir cette évolution des rapports des bras, l'invention propose, à titre d'exemple non exclusif, l'interposition entre le ressort de rappel R et la mâchoire mobile 4 du dispositif démultiplicateur 16 à deux biellettes tel que représenté sur les figures. Dans l'exemple représenté, en plaçant la biellette rectiligne B2 près de l'axe d'articulation fixe A1, le bras d2 du moment créé par la force $F_2$ peut être relativement court. Mais, en forçant l'axe d'articulation A3 à se déplacer sur un arc de cercle autour de l'axe A1, par la biellette B1, le bras d2 augmente lors de l'ouverture tandis que la longueur du bras d1 diminue. Etant donné qu'à l'état fermé de la pince, l'angle entre les axes des biellettes est relativement faible, il est avantageux de donner à la biellette B1 la forme courbée pour faciliter le mouvement de l'axe d'articulation mobile A3 autour de l'axe fixe A1, sous l'effet de la biellette d2.

Pour faire clairement apparaître la particularité de l'invention permettant d'obtenir que la force d'application à la gâchette pour le maintien ouvert de la pince est considérablement plus faible que la force d'application pour l'ouvrir, on donnera ici un exemple non limitatif d'une pince selon l'invention.

Le dispositif démultiplicateur de cette pince comporte un bras B2 d'une longueur entre les axes A4 et A3 de 28 mm et un bras court B1 dont la distance, c'est-à-dire la ligne droite, entre les axes A1 et A3 est de 20 mm. A l'état fermé de la pince, l'angle α entre les bras B2 et la ligne droite a une valeur de 18,36°. A l'état fermé de la pince, la distance entre les axes A4 et A2 est de 54,4 mm et l'angle formé entre la ligne droite reliant les axes A4 et A3, d'une part, et la ligne droite reliant les axes A4 et A2, d'autre part, est de 58°. La distance entre les axes A4 et A1 est de 11 mm.

En réalisant ainsi le dispositif démultiplicateur on obtient qu'à l'état fermé de la pince, le bras d2 ait une longueur de 6,3 mm et le bras d1 la longueur de 19,11 mm. Pour une force de rappel du ressort $F_1$ = 24 N, on obtient une force $F_2$ de 72,81 N. Dû au positionnement indiqué plus haut des axes d'articulation et des biellettes, à l'état ouvert de la pince, le bras d2' présente une longueur de 15,08 mm, et le bras d1' une longueur de 13,19 mm. Dans ce cas, la force du ressort $F_1$' est de 46,56 N. Il en résulte une force $F_2$' de 40,72 N. La distance entre les axes A4 et A2 est maintenant de 63 mm et l'angle entre les lignes A4-A2 et A4-A3 est de 65°. La distance entre les axes A4 et A1 est de 20 mm.

On obtient en outre pour les bras d3 une longueur de 21,68 mm pour la pince fermée et de 12,34 mm pour la pince ouverte. L'angle α présente à l'état d'ouverture de la pince la valeur de 48,91°.

En utilisant les équations indiquées plus haut, avec un bras dA de 40,81 mm, on obtient les valeurs suivantes pour la force d'application sur la gâchette pour l'ouverture Fap et de maintient à l'état d'ouverture de la pince Fap'.

$$\mathrm{Fap} = \frac{MA}{dA} = \frac{F2xd2}{dA} = \frac{78,81\,Nx\,21,68\,mm}{40,81\,mm} = 38,67 \ \mathrm{N}$$

$$\mathrm{Fap'} = \frac{MA'}{dA} = \frac{F2'xd2'}{dA} = \frac{40,72\,Nx\,12,34\,mm}{40,81\,mm} = 12,31 \ \mathrm{N}$$

Il ressort de cet exemple concret basé sur le principe de la configuration des biellettes représentée sur les figures que l'effort de 72,81 N au démarrage de l'ouverture de la pince est supérieur à l'effort de 40,72 N de maintien de la pince totalement ouverte, tout en assurant une force de pression de fermeture des deux mâchoires l'une sur l'autre, ce qui a pour résultat que la force d'application sur la gâchette pour maintenir la pince ouverte est beaucoup plus faible (12,31 N) que la force d'ouverture de la pince (38,67 N).

Bien entendu, de multiples modifications peuvent être apportées à la pince telle que décrite et représentée à titre d'exemple sur les figures.

Il est à noter que l'invention n'est pas limitée à des pinces de mesure de boucle de terre, mais est applicable à toutes autres pinces présentant la structure générale de la pince décrite.

## Revendications

1. Pince de mesure notamment de boucle de terre du type comprenant une mâchoire solidaire d'un support fixe et une mâchoire montée pivotante sur le support fixe, entre une position de fermeture de la pince dans laquelle l'extrémité de la mâchoire mobile (4) est en contact pressé avec l'extrémité de la mâchoire fixe (2) et une position d'ouverture de la pince, et un élément élastique (R) de rappel de la mâchoire mobile dans sa position de fermeture, la mâchoire mobile (4) étant prévue sur un bras (7) d'un levier (6) à deux bras monté pivotant autour d'un axe (A) sur le support fixe de la mâchoire et dont l'autre bras constitue une gâchette (5) d'entraînement en pivotement du levier entre les positions de fermeture et d'ouverture de la pince, **caractérisée en ce qu'**elle comprend un dispositif (16) de démultiplication de la force (Fap) d'ouverture de la pince, par son application sur la gâchette (5), qui est monté entre l'élément élastique de rappel (R) et la gâchette (5), lors de l'ouverture de la pince, par rapport à la force de maintenance ouverte de la pince.

2. Pince de mesure selon la revendication 1, **caractérisée en ce que** le dispositif de démultiplication (16) comprend un agencement de biellettes (B1, B2), qui est monté entre l'extrémité mobile de l'élément élastique (R) dont l'autre extrémité est reliée à un axe d'articulation (A2) monté fixe sur le support, le bras (7) porteur de la mâchoire mobile (4) du levier à deux bras (6) et le support.

3. Pince de mesure selon la revendication 2, **caractérisé en ce que** le dispositif de démultiplication (16) est adapté pour réduire lors du pivotement de la pince dans sa position ouverte, le moment (MA) autour de l'axe (A), que produit la force ($F_2$) s'opposant à l'ouverture de la pince, sous l'effet du ressort de rappel (R).

4. Pince de mesure selon la revendication 3, **caractérisée en ce que** le dispositif de démultiplication est adapté pour réduire, lors du pivotement de la pince dans sa position ouverte, la longueur du bras (d3) du moment (MA) de la force d'opposition autour de l'axe de pivotement (A) du levier à deux bras (6).

5. Pince de mesure selon la revendication 4, **caractérisée en ce qu'**elle comprend deux biellettes (B1, B2) dont l'une est interposée entre le bras (7) porteur de la mâchoire mobile (4) et un axe d'articulation (A3) à l'extrémité mobile de l'élément de rappel (R) et une biellette (B1) qui est interposée entre l'axe d'articulation (A3) et l'axe d'articulation fixe (A1) de façon à forcer, lors de l'ouverture de la pince, l'axe (A3) à se déplacer sur un arc de cercle autour de l'articulation fixe (A1), que la force d'opposition à l'ouverture ($F_2$) est fonction de la force de rappel ($F_1$) de l'élément de rappel ($MF_1$) (R) et du rapport de la longueur du bras (d1) du moment produit par la force de rappel ($F_1$) autour de l'axe d'articulation fixe (A1) et de la longueur du bras (d2) autour de l'axe fixe (A1) du moment ($MF_2$) de la force d'opposition ($F_2$), et **en ce que** le rapport des deux bras (d1, d2) diminue lors de l'ouverture de la pince grâce au déplacement de l'axe d'articulation mobile (A3) sur l'arc de cercle.

6. Pince de mesure selon la revendication 3, **caractérisée en ce que** le moment de la force d'application (Fap) autour de l'axe de pivotement (A) du levier (6) est égale au moment (MA) de la force d'opposition ($F_2$) autour de l'axe (A).

7. Pince de mesure selon la revendication 4, **caractérisée en ce que** le bras du moment (MA) de la force d'opposition ($F_2$) autour de l'axe de pivotement (A) du levier (6) à deux bras diminue lors du pivotement du levier (6) dans la position ouverte de la pince.

8. Pince de mesure selon l'une des revendications 1 à 7, **caractérisée en ce que** l'élément élastique (R) est un ressort de traction.


**Patentansprüche**

1. Messzange, insbesondere für Erdschleife, mit einer festen Spannbacke auf einer festen Halterung und einer Spannbacke, die auf der Halterung schwenkbar zwischen einer Verschlussposition der Zange, in der das Ende der beweglichen Spannbacke (4) in Presskontakt mit dem Ende der festen Spannbacke (2) ist, und einer Öffnungsposition der Zange angebracht ist, und einem elastisches Rückstellelement (R) der beweglichen Spannbacke in ihre Verschlussposition, wobei die bewegliche Spannbacke (4) auf einem Arm (7) eines Hebels (6) mit zwei Armen vorgesehen ist, der schwenkbar um eine Achse (A) auf der festen Halterung der Spannbacke montiert ist, und dessen anderer Arm einen Drücker (5) zum Versetzen des Hebels in ein Schwenken zwischen der Verschluss- und Öffnungsposition der Zange darstellt, **dadurch gekennzeichnet, dass** sie eine Vorrichtung (16) zum Demultiplizieren der Kraft (Fap) zur Öffnung der Zange durch ihre Anwendung auf den Drücker (5) umfasst, der zwischen dem elastischen Rückstellelement (R) und dem Drücker (5) bei der Öffnung der Zange mit Bezug auf die Kraft zum Offenhalten der Zange montiert ist.

2. Messzange nach Anspruch 1, **dadurch gekennzeichnet, dass** die Vorrichtung zum Demultiplizieren (16) eine Stangenanordnung (B1, B2) umfasst, die zwischen dem beweglichen Ende des elastischen Elements (R), dessen anderes Ende mit einer Gelenkachse (A2), die fest auf der Halterung montiert ist, verbunden ist, dem Arm (7), der die bewegliche Spannbacke (4) des Hebels mit zwei Armen trägt, und der Halterung.

3. Messzange nach Anspruch 2, **dadurch gekennzeichnet, dass** die Vorrichtung zum Demultiplizieren (16) ausgelegt ist, um beim Schwenken der Zange in ihre offenen Position das Moment (MA) um die Achse (A), das die Kraft ($F_2$), die sich der Öffnung der Zange entgegensetzt, unter der Wirkung des Rückstellfeder (R) erzeugt, zu reduzieren.

4. Messzange nach Anspruch 3, **dadurch gekennzeichnet, dass** die Vorrichtung zum Demultiplizieren ausgelegt ist, um beim Schwenken der Zange in ihre offene Position die Länge des Arms (d3) des Moments (MA) der Gegenkraft um die Schwenkachse (A) des Hebels mit zwei Armen (6) zu reduzieren.

5. Messzange nach Anspruch 4, **dadurch gekennzeichnet, dass** sie zwei Stangen (B1, B2) umfasst, von denen eine zwischen dem Arm (7), der die bewegliche Spannbacke (4) trägt, und einer Gelenkachse (A3) am beweglichen Ende des Rückstellelements (R) angebracht ist, und eine Stange (B1), die zwischen der Gelenkachse (A3) und der festen Gelenkachse (A1) angebracht ist, um bei der Öffnung der Zange die Achse (A3) zu zwingen, sich auf einem Kreisbogen um das feste Gelenk (A1) zu bewegen, dass die Gegenkraft zur Öffnung ($F_2$) eine Funktion der Rückstellkraft ($F_1$) des Rückstellelements ($MF_1$) (R) und des Verhältnisses der Länge des Arms (d1) des Moments, erzeugt durch die Rückstellkraft (F1) um die feste Gelenkachse (A1), und der Länge des Arms (d2) um die feste Achse (A1) des Moments ($MF_2$) der Gegenkraft ($F_2$) ist, und dadurch, dass sich das Verhältnis der zwei Arme (d1, d2) bei der Öffnung der Zange dank der Bewegung der beweglichen Gelenkachse (A3) auf dem Kreisbogen verringert.

6. Messzange nach Anspruch 3, **dadurch gekennzeichnet, dass** das Moment der Kraft zur Anwendung (Fap) um die Schwenkachse (A) des Hebels (6) gleich dem Moment (MA) der Gegenkraft ($F_2$) um die Achse (A) ist.

7. Messzange nach Anspruch 4, **dadurch gekennzeichnet, dass** sich der Arm des Moments (MA) der Gegenkraft ($F_2$) um die Schwenkachse (A) des Hebels (6) mit zwei Armen (6) beim Schwenken des Hebels (6) in der offenen Position der Zange verringert.

8. Messzange nach einem der Ansprüche 1 bis 7, **dadurch gekennzeichnet, dass** das elastische Element (R) eine Zugfeder ist.

**EP 2 756 923 B1**

**Claims**

1. A clamp meter, in particular for an earth loop, of the type including a jaw secured to a stationary mounting and a jaw mounted pivoting on the stationary mounting, between a closed position of the clamp in which the end of the movable jaw (4) is in pressed contact with the end of the stationary jaw (2) and an open position of the clamp, and a resilient element (R) for returning the movable jaw into its closed position, the movable jaw (4) being provided on an arm (7) of a lever (6) with two arms mounted pivoting around a pin (A) on the stationary mounting of the jaw and the other arm of which constitutes a trigger (5) for driving the pivoting of the lever between the closed and open positions of the clamp, **characterized in that** it comprises a device (16) for reducing the opening force (Fap) of the clamp, by its application on the trigger (5), which is mounted between the resilient return element (R) and the trigger (5), when the clamp is opened, relative to the force to keep the clamp open.

2. The clamp meter according to claim 1, **characterized in that** the reducing device (16) includes an arrangement of connecting rods (B1, B2), which is mounted between the movable end of the resilient element (R) whereof the other end is connected to a hinge pin (A2) mounted stationary on the mounting, the arm (7) bearing the movable jaw (4) of the lever with two arms (6) and the mounting.

3. The clamp meter according to claim 2, **characterized in that** the reducing device (16) is suitable for reducing, during the pivoting of the clamp in its open position, the moment (MA) around the pin (A), produced by the force ($F_2$) opposing the opening of the clamp, under the effect of the return spring (R) .

4. The clamp meter according to claim 3, **characterized in that** the reducing device is suitable for reducing, during the pivoting of the clamp in its open position, the length of the arm (d3) of the moment (MA) of the opposition force around the hinge pin (A) of the lever with two arms (6).

5. The clamp meter according to claim 4, **characterized in that** it includes two connecting rods (B1, B2), one of which is inserted between the arm (7) bearing the movable jaw (4) and a hinge pin (A3) at the movable end of the return element (R), and a connecting rod (B1) that is inserted between the hinge pin (A3) and the stationary hinge pin (A1) so as to force, during the opening of the clamp, the pin (A3) to move over an arc of circle around the stationary pin (A1), **in that** the force opposing the opening ($F_2$) depends on the return force ($F_1$) of the return element ($MF_1$) (R) and the ratio of the length of the arm (d1) at the moment produced by the return force ($F_1$) around the stationary hinge pin (A1) and of the length of the arm (d2) around the stationary pin (A1) at the moment ($MF_2$) of the opposition force (F2), and **in that** the ratio of the two arms (d1, d2) decreases during the opening of the clamp owing to the movement of the movable hinge pin (A3) over the arc of circle.

6. The clamp meter according to claim 3, **characterized in that** the moment of the application force (Fap) around the hinge pin (A) of the lever (6) is equal to the moment (MA) of the opposition force ($F_2$) around the pin (A).

7. The clamp meter according to claim 4, **characterized in that** the arm of the moment (MA) of the opposition force ($F_2$) around the hinge pin (A) of the lever (6) with two arms decreases during the pivoting of the lever (6) in the open position of the clamp.

8. The clamp meter according to one of claims 1 to 7, **characterized in that** the resilient element (R) is a traction spring.

7

Fig. 1

*Fig.2*

*Fig.3*

_Fig.4_

_Fig.5_

**EP 2 756 923 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0836099 A1